# EUROPEAN PATENT APPLICATION

(11) **EP 1 484 794 A1**
(43) Date of publication of application: **08.12.2004**
(21) Application number: 03291371.7
(22) Date of filing: 06.06.2003
(51) Int. Cl.: H01L 21/78, H01L 21/20, C23C 16/44, C23C 14/00

(54) **A method for fabricating a carrier substrate**

(71) Applicant: S.O.I. Tec Silicon on Insulator Technologies S.A., 38190 Bernin (FR)
(72) Inventor: Faure, Bruce, 38000 Grenoble (FR)
(74) Representative: Grünecker, Kinkeldey, Stockmair & Schwanhäusser Anwaltssozietät

(57) **Abstract**

The invention relates to a method of preparation of a carrier substrate in a fabrication process of homo- or heteroepitaxial films or layers, comprising the steps of providing a crystalline or mono-crystalline base substrate. It is the object of the present invention to provide a process of preparation of a carrier substrate which further reduces the influence of the substrate while being at the same time economically viable. The object is solved by providing an epitaxial stiffening layer on a surface of the base substrate and isolating the stiffening layer, in particular together with the sub-layer of the base substrate, from the remainder of the base substrate, whereby the isolated material creates the carrier substrate.

## Description

The invention relates to a method of preparation of a carrier substrate in the fabrication process of homo- or heteroepitaxial films or layers.

Epitaxy is a process during which a crystalline layer of a material is deposited on a substrate, which is also crystalline. The epitaxial growth is characterised in that the crystalline structure of the substrate is reproduced in the epitaxial layer of the material to be grown. Thereby, the defects of the substrate are usually reproduced in the epitaxial layer also. Those epitaxial layers usually find their application in electronic or optoelectronic applications. Of particular interest are, for instance, gallium nitride epitaxial layers which, due to their large band gap, are used in blue, violet or ultraviolet laser diodes.

Epitaxial techniques can be essentially separated into two families. First of all, there is homoepitaxy, wherein the material to be grown is of the same nature as the substrate, which means that essentially their crystallographic structure and their chemical nature are identical. Examples used in industry are the homoepitaxy of silicon on a silicon substrate or the epitaxial growth of gallium arsenide on a substrate of gallium arsenide.

Of even greater interest is so-called heteroepitaxy, wherein the film to be grown is grown on a substrate of a different nature. This is especially important in cases where the desired material is not available in the form of a crystalline substrate. There are two major problems inherent in heteroepitaxy: the difference in the crystalline structure of the two materials, and the difference in their thermal expansion coefficients. These differences lead to stress inside the film and as a consequence to defects such as dislocations.

In addition to the above-mentioned problems leading to insufficient quality of the epitaxial layer, it is also possible that the substrate, due to its intrinsic characteristics, is not fully adapted to the application of the device employing the special characteristic of the epitaxial layer. For example, if one would grow gallium nitride on silicon carbide, relatively good epitaxial growth could be achieved; however, if the gallium nitride structure would be used as a light-emitting device, the silicon carbide substrate would not be advantageous, as it would trap too much light.

In the state of the art, there are several approaches known for overcoming the above-mentioned problems; however, none proposes a substrate which allows homo- as well as heteroepitaxial growth and overcomes each of the three distinct problems mentioned above. For example US 5,759,898 has shown that it is possible to successfully grow an epitaxial silicon germanium thin film on a silicon-on-insulator wafer, wherein the silicon germanium layer grows on a thin silicon film (about 16 nm), which itself is positioned on a layer of silicon dioxide which is in turn positioned on a silicon wafer. In such a structure, the appearance of dislocations in the silicon germanium film is greatly diminished in comparison with a silicon germanium film directly grown on a bulk silicon substrate.

Another approach is shown in WO 99/39377, wherein a so-called compliant substrate is created by ion implantation. In this approach, a fragilised layer inside the material is obtained by ion implantation, which at the same time creates a very thin layer on the top. This top layer is partially isolated from the substrate via the fragilised layer, and absorbs to some extent the mismatch in crystalline structure and thermal expansion of the epitaxial layer to be grown and the top layer of the original substrate, thereby causing at least a partial relaxation of the stress of the epitaxial layer.

These two approaches overcome to some extent the above-mentioned problems; however, due to the presence of the original substrate a negative influence cannot be excluded, and in cases where the presence of the original substrate is incompatible with the application of the grown epitaxial layer, further process steps are needed to remove the original substrate, leading to higher production costs.

It is therefore the object of the present invention to provide a process of preparation of a carrier substrate which further reduces the influence of the substrate while being at the same time economically viable. The object is solved with a method according to claim 1.

The detachment of the carrier substrate from the remainder of the base substrate solves, to an important extent, the above-mentioned problems. In cases where a commercially available base substrate is not compatible with the later application of the epitaxial film to be grown, this incompatibility is diminished as the obtained carrier substrate is independent from the remainder of the substrate, and therefore is not affected by the undesirable properties. The influence of the still-present sub-layer can thereby be minimised in the process, and thus does not play a major role.

Concerning the problems of crystallographic structure incompatibility between the base substrate and the desired epitaxial film, and also the differences in their thermal expansion coefficients, the creation of a carrier substrate according to the invention is also advantageous, as the stiffening layer provided on top of the base substrate is in itself already being grown by a heteroepitaxial method. This means that by choosing the right material for the stiffening layer, which choice depends on the properties of the base material and the future epitaxial film, these incompatibilities can already be reduced. Furthermore, strain that might occur during the growth of the desired epitaxial layer on top of the carrier substrate can be absorbed to a large extent inside the carrier substrate. Thus, carrier substrates manufactured by the inventive process will serve to provide better quality epitaxial films.

To achieve an isolated carrier substrate, the stiffening layer has a thickness sufficient to enable a free-standing character of the carrier substrate. This means that the carrier substrate has to be sufficiently robust to withstand the process step of isolation from the remainder of the substrate, or sufficiently stable that it can be taken away from the remainder of the substrate by appropriate means, for example in order to place it in a different apparatus for further processing.

In a further embodiment of the inventive process, atomic species are implanted into the base substrate, creating a layer-like zone inside the base substrate, essentially parallel to the surface, thereby defining a weak interface between the remainder of the base substrate and the future carrier substrate, consisting of the stiffening layer and the sub-layer.

This is a very elegant way of defining the area where, in a later process step, detachment will take place between the carrier substrate and the remainder of the base substrate.

It can be particularly advantageous to use hydrogen ions and/or rare gas as the atomic species in the implantation step. These species allow the creation of a weak layer in a controllable manner.

In a further preferred embodiment, the implantation takes place before providing the stiffening layer. It is known that during ion implantation the implanted ions do not only disturb the crystalline structure on the desired level inside the substrate, but that defects are also introduced into the layer through which the ions travel. This means that if ion implantation were to take place after providing the stiffening layer, the stiffening layer would contain defects that might influence the quality of the epitaxial layer to be grown. Therefore, it is advantageous to perform ion implantation first and then the growth of the stiffening layer.

In a variant of the invention, the sub-layer can have a thickness of up to approximately five micrometers, specifically up to approximately two micrometers, more specifically a thickness of up to approximately one micrometer. Choosing a relatively thick sub-layer has the advantage that in order to achieve the free-standing carrier substrate the thickness of the stiffening layer can be relatively small, thereby speeding up the process. On the other hand, by choosing a sub-layer of a relatively small thickness, any undesirable properties of the sub-layer material, as for instance light absorbency in optical applications, can be minimised. Thickness control of the sub-layer can easily be managed by adjusting the energy of the ions. The thickness can also be below the values indicated. According to one embodiment, the sub-layer and/or the stiffening layer can be removed from the carrier substrate.

Another aspect of the inventive method is to apply a thermal treatment to achieve isolation between the carrier substrate and the remainder of the base substrate. This usually occurs after or starts during the application of the stiffening layer. Due to the thermal treatment, the weak layer-like zone inside the base substrate is further weakened, which leads to a rupture between the remainder of the base substrate and the stiffening layer together with the sub-layer. Thermal treatments are generally easy to implement and to control. If necessary, a mechanical treatment can be applied to attain the final detachment.

A further preferred embodiment consists of applying, prior to implantation, a sacrificial layer, in particular a thin silicon dioxide (SiO₂ layer), to the surface of the base substrate. Through this sacrificial layer, implantation takes place in a subsequent process step. Doing so helps to protect the substrate surface from typical organic and particle contamination, which can occur during high-energy ion implantation.

In an advantageous manner, the sacrificial layer can be removed prior to providing the stiffening layer or, in other words, after the ion implantation. As mentioned above, organic contamination can result from high-energy ion implantation. When applying a sacrificial layer, the contamination is fixed on this layer, and by removing the layer in a subsequent step the contamination is also moved. Furthermore, the crystallographic properties or the thermal expansion coefficient of the sacrificial layer might not be suitable for further epitaxial growth of the desired stiffening layer or epitaxial layer.

In a further preferred embodiment, the stiffening layer can be applied by deposition, specifically by epitaxial deposition, more specifically by molecular beam epitaxy (MBE), by metal-organic chemical vapour (MOCVD), by hydride vapour phase epitaxy (HVPE) or by sputtering. These methods will allow the growth of a good quality crystallised stiffening layer, the quality of which is crucial for successful growth of good quality epitaxial films for the final application.

In another aspect of the invention, the stiffening layer can be grown to a thickness sufficient to enable a self-supporting character of the carrier substrate, specifically a thickness of at least approximately five micrometers, more specifically of at least approximately 10 micrometers. These thicknesses are related to the fact that the stiffening layer together with an eventually present sub-layer provide sufficient stability to the carrier substrate so that its surface does not become deformed or destroyed during the isolation step.

Prior to providing the stiffening layer, and to improve the quality of the stiffening layer, the surface of the base substrate can be pre-treated, in particular by HF etching, plasma etching or standard cleaning one (SC1) with standard cleaning two (SC2).

A further way to improve the quality of the carrier substrate can be to provide in addition to the stiffening layer at least one additional layer, which is provided either on top of the stiffening layer or between the base substrate and the stiffening layer. These layers are helpful in overcoming the residual differences in crystallographic structure and thermal expansion. Therefore, by applying these kinds of additional layers, residual stresses can be further diminished, leading to improved epitaxial films.

To even further improve the quality of the epitaxial layer to be grown, in another preferred embodiment at least two additional layers are provided on top of the base substrate, wherein at least one additional layer is provided prior to implanting atomic species. The epitaxy of a first layer or a multi-layer structure on the base substrate is thus performed before the atomic species are implanted. The first layer or the multi-layer structure can then be used as a nucleation layer for the stiffening layer growth, which takes place after the implanting step.

In a further variant of the invention the atomic species are implanted in the at least one additional layer provided prior to implanting the atomic species, therefore creating a layer-like zone inside the at least one additional layer essentially parallel to the surface, and thereby defining a weak interface. This means that after the detachment step, no material from the original substrate is present and thus the residual stress can be further diminished, leading to improved epitaxial films. Actually, in this case the remainder of the base substrate is then constituted out of the entire base substrate itself and the part of the at least one additional layer which is situated below the weak interface towards the base substrate.

In an advantageous manner, the surface of the remainder of the base substrate, after isolation of the carrier substrate, is polished, in particular by chemical-mechanical polishing (CMP), and re-used as a base substrate in a subsequent carrier substrate preparation process. This means that eventually out of a relatively expensive mono-crystalline base substrate, a certain, non-negligible amount of high quality carrier substrates can be manufactured.

In a further preferred embodiment, the base substrate is made out of one of the group of silicon, silicon carbide, sapphire, gallium arsenide, indium phosphide (InP) or germanium (Ge). For epitaxial growth, these substrates are usually mono-crystalline and can present surfaces of various crystalline directions. These substrates are readily available and because their properties vary, they form a good base for growing a large number of different carrier substrates, thereby permitting the growth of an even larger amount of epitaxial layers with good crystalline properties.

To even further improve the quality of the epitaxial layer to be grown, in another preferred embodiment the epitaxial stiffening layer is made of the same material as the intended epitaxial film or layer to be grown on the carrier substrate in a later fabrication stage. This means that between the epitaxial film and the carrier substrate there is nearly no difference in crystalline structure and thermal expansion coefficients, resulting in high quality epitaxial films.

In a further variant of the invention, the stiffening layer can have a crystalline structure and/or a thermal expansion coefficient similar to that of the intended epitaxial film or layer to be grown on the carrier substrate in a later fabrication stage. When the difference in crystalline structure or thermal expansion coefficient of the base substrate and the intended epitaxial film would be too great, it is advantageous to choose a stiffening layer of a material that has its properties somewhere in between those two values. By doing so, a good crystalline quality of the stiffening layer can be obtained and also in subsequent fabrication steps a good quality epitaxial film.

In a preferred embodiment the stiffening layer can be made out of one or several of the group of gallium nitride (GaN), aluminum nitride (AIN), indium nitride (InN), silicon germanium (SiGe), indium phosphite (InP), gallium arsenide (GaAs) or alloys made out of those materials, like AIGaN, InGaN, InGaAs, or AlGaAs. These materials are particularly of interest for electronic as well as opto-electronic applications and can be arranged in the form of several layers within the stiffening layer.

In cases where an additional or several layers are provided between the base substrate and the stiffening layer of gallium nitride or the like, it is especially advantageous that the buffer layer is made out of one or several of the group of AIN, GaN, AIGaN or a combination thereof depending on the materials of the base substrate and the stiffening layer. By using these materials as buffer layers, eventually occurring constraints can be limited, leading to an amelioration of the quality of the epitaxial films to be grown. These materials can be arranged in the form of several layers.

In a further variant of the invention, the back side surface of the carrier substrate, which is the surface which does not receive the epitaxial layer to be grown and which is created as a consequence of the detachment, has a surface roughness in a range of approximately 20-200 Å RMS, specifically in a range of approximately 20-150 Å RMS, more specifically in a range of approximately 20-100 Å RMS. Due to this fact, even though the carrier substrate is actually separated from the remainder of the substrate and not influenced by its presence, there will be sufficient friction between the carrier substrate and the remainder of the substrate so that the position of the carrier substrate can be relatively well maintained on top of the remainder of the substrate. Therefore, it is possible to continue with the process in the same deposition apparatus, growing the next layer ― which could be another buffer layer or the final epitaxial layer that was intended to be grown ― without having to handle the carrier substrate in a specific way, for example securing it on a substrate holder.

The above-mentioned object is also attained by a carrier substrate designated to be used in the fabrication process of homo- or heteroepitaxial films, manufactured according to at least one of claims 1 to 19.

It is especially advantageous to use the carrier substrate according to claim 20 in the process of growing an epitaxial film, in particular a heteroepitaxial film, more specifically a film made out of gallium nitride, silicon germanium, aluminum nitride or indium nitride.

Specific embodiments of the present invention will become more apparent from the following detailed description with reference to the accompanying drawing, in which:

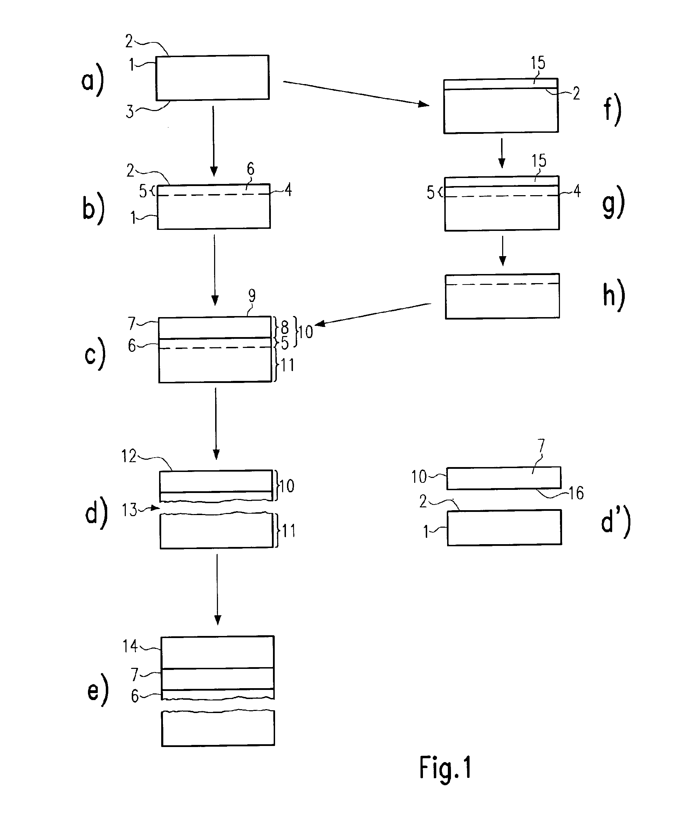

- Fig. 1: schematically shows an inventive preparation process diagram for the preparation of a carrier substrate; wherein
- Figs. 1a to 1e: schematically show the preparation method of a carrier substrate, which is used in the fabrication process of a homo- or heteroepitaxial film, one possible result of which is shown in Fig. 1e; and wherein
- Figs. 1f to 1h: schematically show a second embodiment which consists of additional processing steps,
- Fig. 1d': schematically shows the separation between base substrate and carrier substrate in an alternative process.

The process, shown in Figs. 1a ― 1h, can be run, for instance, on a Smart-cut® -like process production line.

Fig. 1a shows a base substrate which acts as the starting point of the preparation process of the carrier substrate. This substrate 1 has a front side 2 and a back side 3. For homo- or heteroepitaxial applications, the base substrate is usually of a crystalline, in particular a mono-crystalline type. At least one surface, here the front side 2, is sufficiently well-defined to serve as a starting point for the growth of an epitaxial, homo- or heteroepitaxial layer or film. Usually, the surface is polished and prepared for epitaxy, and substantially in accordance with typical crystalline directions. The exact size of the base substrate 1 is not of major importance, but at least the surface of the front side 2 should be sufficiently large to allow the growth of a sufficiently big carrier substrate suitable to the subsequent needs of the devices. Particularly relevant are wafers made out of silicon, silicon carbide, sapphire, gallium arsenide, indium phosphide or germanium. These wafers are usually disc-shaped, but rectangular or square formats are also available. Disc-like wafers can have diameters of from 50.8 mm (2 inches) up to 300 mm today, but even larger diameters are foreseen for the future.

Fig. 1b shows the result of the next process step. Gaseous species, in particular hydrogen ions, are implanted into the base substrate 1. The implantation takes place through the front side 2 of the base substrate 1. The implanted species create a weak layer-like zone 4, which is essentially parallel to the front-side surface 2 of the base substrate 1. The depth 5 of the layer-like zone 4 can be adjusted by the energy of the implanted species. For example, in the case of hydrogen atoms implanted into silicon carbide, an energy of approximately 100 KeV creates the layer-like zone at a depth of approximately 6000 Å. The zone between the surface 2 and the layer-like zone 4 defines the sub-layer 6. It is particularly advantageous to apply a Smart-cut® process to the ion implantation.

Fig. 1c shows the result of the subsequent processing step, which is the deposition of the stiffening layer 6. At the beginning of the process, the base substrate 1 has been chosen so that its material is compatible with the epitaxy of the stiffening layer 7. In particular, it should be compatible with heteroepitaxial growth.

In this first epitaxial growth step, the stiffening layer is grown to a thickness of approximately 1 to 10 micrometers. The thickness 8 of the stiffening layer 7 plus the thickness 5 of the sub-layer 6 needs to be sufficient to create a carrier substrate 10 that is free-standing, which means that the quality of the surface 9 of the stiffening layer 7 does not deteriorate at or after the point when the carrier substrate 10 becomes separated from the remainder of the base substrate 11. Typical stiffening layer materials are gallium nitride (GaN), aluminum nitride (AIN), indium nitride (InN), silicon germanium (SiGe), indium phosphite (InP), gallium arsenide (GaAs) or alloys made out of those materials, like AIGaN, InGaN, InGaAs, AIGaAs. However, in future applications it is possible that other materials need to play the role of stiffening layer. Usually, the stiffening layer 7 can be applied by any deposition method leading to epitaxial growth. However, growth by molecular beam epitaxy (MBE), metal-organic chemical vapour (MOCVD), hydride vapour phase epitaxy (HVPE) or sputtering is particularly suitable.

Fig. 1d shows the result of the subsequent process step, which is the thermal treatment of the created structure, leading to the isolation of the carrier substrate 10 from the remainder of the base substrate 11. Due to the fact that the total thickness sum of thickness 5 and 8 of the carrier substrate 10 is sufficient to prevent the formation of defects of the morphology of the surface 12 opposite to the zone 13 where the fracture occurs, the surface 12 does not deteriorate. The roughness of the surface 13 where the fracture occurs is sufficient to keep the carrier substrate 10 in a secure position on top of the remainder of the substrate 11 due to frictional interaction. This can be advantageous for the subsequent process steps, in particular when the subsequent process steps are performed in the same apparatus without removing the carrier substrate 10. Typically, roughnesses in the range of approximately 20-200 Å RMS, more specifically in a range of approximately 20-150 Å RMS and even more specifically in a range of approximately 20-100 Å RMS can be achieved in such a process.

Using an appropriate process technique, different to the described Smart-cut^{□}-like process, it is possible to provoke a fracture between the carrier substrate 10 and the base substrate 1 at the interface 2 between the stiffening layer 7 and the base substrate 1, as shown in Fig 1d'. Thus, by doing so, the carrier substrate is entirely made of the material of the stiffening layer 7. Depending on the process applied, the backside (16) of the stiffening layer 7, representing the carrier substrate 10, may or may not need further polishing.

Fig. 1e shows the result of a subsequent processing step, which is the epitaxial growth of the desired material. During this second deposition step, performed in a manner similar to the first one, the planned epitaxial film 14 is obtained. Depending on the goal of the process, the material of the second film 14 can be the same as the material of the stiffening layer 7 of the carrier substrate 11 or, in a heteroepitaxial growth, the material of layer 14 can be different from that of the stiffening layer 7. As the carrier substrate 10 is detached from the remainder of the base substrate 11, the crystalline quality of this second layer 14 is very good. Defects due to the stress can be minimised. Usually negative effects of the sub-layer 6 of the carrier substrate 10, which contains the material of the base substrate 1, can be ignored, as its thickness is usually chosen to be clearly inferior to that of the stiffening layer 7, which in fact means that this carrier substrate 11 behaves like a bulk substrate of the material of the stiffening layer 7. This also means that the thickness of the second film 14, especially in cases where the material of layer 14 and of layer 7 is the same, is not limited. It is even possible to grow a film 14 with a laterally variable thickness. Actually the carrier substrate 10 does not impose limitations on the structure or thickness of the second layer 14. The process can be applied, for example, to grow mono-crystals of excellent quality, especially where the two materials of layer 14 and 7 are the same; or heterostructures can be built, leading to devices like laser diodes.

In an optional processing step (not shown), the sub-layer 6 can be removed, for example by using a dry or humid etch technique.

The remainder 11 of the base substrate 1 can be polished, in particular by chemical-mechanical polishing (CMP), and be re-used as a base substrate 1 in a subsequent carrier substrate 10 manufacturing process.

Figs. 1f to 1h show a variant of the already described process. With respect to the first embodiment, they fit in between the process steps shown in Figs. 1a and 1c and thereby replace the step corresponding to Fig. 1b.

Fig. 1f shows the result of the process step consisting of depositing a sacrificial layer 15 on top of the base substrate 1. This sacrificial layer 15 is for example made out of silicon dioxide, deposited by one of the usual methods known in the prior art. This sacrificial layer protects the front side 2 of the base substrate 1 from organic and particle contamination which might occur during the subsequent ion implantation process step.

Fig. 1h shows the result of the ion implantation step. It is comparable to the process step described in combination with Fig. 1b. However, due to the presence of the sacrificial layer 15 the depth 5 of the layer-like zone 4 is smaller than in the first embodiment, because at the same energy level the gaseous species now have to travel through the sacrificial layer and, as a consequence, stop at a depth 5 which is lower.

Fig. 1h shows the result of the sacrificial layer removal step. After the ion implantation, the sacrificial layer 15 is removed in order to achieve a clean front side 2 surface of the base substrate 1. The next step is the growth of the stiffening layer which is comparable to what has been described with respect to Fig. 1c.

Several further alternatives lead to different embodiments. They are not shown in the Figures, but will be briefly explained below.

In order to further improve the quality of the stiffening layer 7 as well as the second epitaxial layer 14, further steps can be included. Prior to applying the stiffening layer, the front side surface 2 can be prepared in order to facilitate the nucleation of the epitaxial stiffening layer. Chemical etching using hydrofluoric acid (HF), plasma etching, standard cleaning one (SC1) with standard cleaning two (SC2) or any other suitable cleaning technique may be used to achieve this. It is also possible to use a thermal oxidation and oxide removal before the ion implantation, in order to remove surface defects from the base substrate.

It is also possible to use at least one additional layer as a buffer layer in order to improve the quality of the stiffening layer. These additional layers grown on the substrate 1 relieve any stress that might occur inside the stiffening layer. Typical materials are aluminum nitride, gallium nitride, aluminum gallium nitride or a combination thereof. Sophisticated buffer techniques like lateral overgrowth or the like can also be applied. The same kind of additional layers can also be applied between the carrier substrate 10 and the desired epitaxial layer 14. It is possible to grow the additional layers before and/or after the implantation step. In a further variant, implantation place the weak zone inside one of the additional layers that have been grown prior to implantation.

Ideally, at least process steps 1c to 1e take place in one apparatus without moving the carrier substrate 10, thus reducing the risks of introducing contamination or scratches on the carrier substrate. Alternatively, if it is advantageous for the planned process, it is possible to separate the carrier substrate 10 from the remainder of the substrate 11 after step 1d. Therefore, the thickness of the carrier substrate needs to be sufficient for it to be handled and moved from one apparatus to another.

The epitaxial films 14 that can be obtained by this preparation method are in particular films made out of gallium nitride, silicon germanium, aluminum nitride or indium nitride. Below, an example of fabrication of an epitaxial gallium nitride film on a silicon carbide base substrate will be described.

As a base substrate, mono-crystalline silicon carbide of a 6H or 4H polytype with silicon terminated surface, or 3C (three cubic) silicon carbide is provided. Alternatively, the process could also be applied to a base substrate made out of sapphire. Ion implantation is performed using hydrogen ions with a dose between 2 and 8 x 10¹⁶ H+/cm² with an energy between 30 and 210 KeV, in particular a dose of 5 x 10¹⁶ H+/cm² with an energy of 120 KeV. The ions are implanted through the front side surface 2 of the base substrate 1. As mentioned above, a sacrificial layer 15 can be used to prevent contamination. In the case of silicon carbide it is possible to grow a silicon dioxide layer of a couple of hundred A by thermal process. After implantation, the silicon dioxide can be removed using hydrofluoric acid (HF), in a ten percent concentration. Usually a 20 minute period of time is sufficient to remove the oxide layer.

In the next step, gallium nitride is deposited on the implanted silicon carbide base substrate by means of MBE at a temperature of less than 800°C. This first epitaxial layer corresponds to the stiffening layer 7 and has a thickness of some microns. Alternatively, prior to depositing gallium nitride, a buffer technique can be used. Another alternative is to clean the surface prior to deposition by chemical etching using hydrofluoric acid, or by plasma etching or SC1 with SC2 cleaning.

In the next step, the sample is heated to a temperature of more than or equal to 900°C and a fracture between the carrier substrate 10 and the remainder of the silicon carbide base substrate 11 takes place. Then a second epitaxial growth step occurs, wherein gallium nitride is grown to a thickness of up to about 200-300 micrometers, whereby the growth speed can be relatively high, e.g. 50 µm per hour.

Finally, the substrate and the newly grown gallium nitride layer are brought back to room temperature and it is possible to separate the gallium nitride film from the substrate. Using chemical means, the back side of the gallium nitride can be cleaned, so that any remaining silicon carbide is removed. The original silicon carbide base substrate will be recycled by polishing its surface using chemical-mechanical polishing.

## Claims

1. A method of preparation of a carrier substrate (10) in the fabrication process of homo- or heteroepitaxial films or layers (14), comprising the steps of:
providing a crystalline or mono-crystalline base substrate (1),
providing an epitaxial stiffening layer (7) on a surface (2) of the base substrate (1), isolating the stiffening layer (7), in particular together with a sub-layer (6) of the base substrate (1), from the remainder of the base substrate (11), whereby the isolated material creates the carrier substrate (10).

2. A method of preparation of a carrier substrate (10) according to claim 1,
**characterised in that**
atomic species are implanted in the base substrate (1), creating a layer-like zone (4) inside the base substrate (1) essentially parallel to the surface (2), thereby defining a weak interface between the remainder of the base substrate (11) and the sub-layer (6).

3. A method of preparation of a carrier substrate (10) according to claim 2
**characterised in that**
the atomic species are hydrogen ions and/or rare gas.

4. A method of preparation of a carrier substrate (10) according to claim 2 or 3
**characterised in that**
the implantation takes place before providing the stiffening layer (7).

5. A method of preparation of a carrier substrate (10) according to at least one of claims 2 to 4
**characterised in that**
the sub-layer (6) has a thickness of up to approximately 5µm, specifically up to approximately 2µm, more specifically a thickness of up to approximately 1 µm.

6. A method of preparation of a carrier substrate (10) according to at least one of claims 2 to 5
**characterised in that**
the isolation between the carrier substrate (10) and the remainder of the base substrate (11) is achieved by thermal treatment.

7. A method of preparation of a carrier substrate (10) according to at least one of claims 2 to 6
**characterised in that**
prior to implantation a sacrificial layer (15), in particular a thin silicon dioxide (SiO₂) layer, is applied to the surface (2) of the base substrate (1), through which implantation will take place.

8. A method of preparation of a carrier substrate (10) according to claim 7
**characterised in that**
the sacrificial layer (15) is removed prior to providing the stiffening layer (7).

9. A method of preparation of a carrier substrate (10) according to at least one of claims 1 to 8
**characterised in that**
the stiffening layer (7) is applied by deposition, in particular by epitaxial deposition, more particularly by molecular beam epitaxy, (MBE), by metal-organic chemical vapour (MOCVD), by hydride vapour phase epitaxy (HVPE) or by sputtering.

10. A method of preparation of a carrier substrate (10) according to at least one of the claims 1 to 9
**characterised in that**
the stiffening layer (7) is grown to a thickness sufficient to enable a self-supporting character of the carrier substrate (10), specifically a thickness of at least approximately 5µm, more specifically of at least approximately 10µm.

11. A method of preparation of a carrier substrate (10) according to at least one of the claims 1 to 10
**characterised in that**
prior to providing the stiffening layer (7), the surface (2) of the base substrate (1) is pre-treated, in particular by HF etching, plasma etching or standard cleaning one (SC1) with standard cleaning two (SC2).

12. A method of preparation of a carrier substrate (10) according to at least one of the claims 1 to 11
**characterised in that**
in addition to the stiffening layer (7) there is provided at least one additional layer either on top of the stiffening layer or between the base substrate (1) and the stiffening layer (7).

13. A method of preparation of a carrier substrate (10) according to claim 12
**characterised in that**
at least two additional layers are provided on top of the base substrate and wherein at least one additional layer is provided prior to implanting atomic species.

14. A method of preparation of a carrier substrate (10) according to claim 13
**characterised in that**
the atomic species are implanted in the at least one additional layer, provided prior to implanting the atomic species, creating a layer-like zone inside the at least one additional layer essentially parallel to the surface, thereby defining a weak interface.

15. A method of preparation of a carrier substrate (10) according to at least one of the claims 1 to 14
**characterised in that**
after isolation of the carrier substrate (10), the surface (13) of the remainder of the base substrate (11) is polished, in particular by chemical mechanical polishing, and reused as a base substrate (1) in a subsequent carrier substrate (10) preparation process.

16. A method of preparation of a carrier substrate (10) according to at least one of the claims 1 to 15
**characterised in that**
the base substrate (1) is made out of one of the group of silicon, silicon carbide, sapphire, gallium arsenide, indium phospide (InP) or germanium (Ge).

17. A method of preparation of a carrier substrate (10) according to at least one of the claims 1 to 16
**characterised in that**
the epitaxial stiffening layer (7) is made of the same material as the intended epitaxial film (14) or layer to be grown on the carrier substrate (10) in a later fabrication stage.

18. A method of preparation of a carrier substrate (10) according to at least one of the claims 1 to 16
**characterised in that**
the stiffening layer (7) has a crystalline structure and a thermal expansion coefficient similar to that of the intended epitaxial film (14) or layer to be grown on the carrier substrate (10) in a later fabrication stage.

19. A method of preparation of a carrier substrate (10) according to at least one of the claims 1 to 18
**characterised in that**
the stiffening layer (7) is made out of one or several of the group of gallium nitride (GaN), aluminum nitride (AIN), indium nitride (InN), silicon germanium (SiGe), indium phosphite (InP), gallium arsenide (GaAs) or alloys made out of those materials, like AIGaN, InGaN, InGaAs or AIGaAs.

20. A method of preparation of a carrier substrate (10) according to at least one of the claims 12 to 19
**characterised in that**
the additional layer between the base substrate (1) and a stiffening layer (7) of GaN or the like is a buffer layer, the buffer layer being made out of one or several of the group of AIN, GaN, AIGaN or a combination thereof.

21. A method of preparation of a carrier substrate (10) according to at least one of the claims 6 to 20
**characterised in that**
a backside surface (13) of the carrier substrate (10), being the surface which does not receive the final epitaxial layer and which is created as a consequence of the detachment, has a surface roughness in a range of approximately 20-200 Å RMS, specifically in a range of approximately 20-150 Å RMS, more specifically in a range of approximately 20-100 Å RMS.

22. A carrier substrate (10), designated to be used in the fabrication process of homo- or heteroepitaxial films, manufactured according to at least one of the claims 1 to 21.

23. The use of the carrier substrate (10) according to claim 22 in the process of growing an eptiaxial film (14), in particular a heteroepitaxial film, more particularly a film made out of GaN, SiGe, ALN or InN.
